# EUROPÄISCHE PATENTSCHRIFT

(11) **EP 1 229 775 B1**
(45) Veröffentlichungstag und Bekanntmachung des Hinweises auf die Patenterteilung: **09.06.2010**
(21) Anmeldenummer: 02001454.4
(22) Anmeldetag: 21.01.2002
(51) Int. Cl.: H05K 7/18

(54) **Serverrack**
Rack for server
Rack pour serveur

(30) Priorität: 06.02.2001 DE 10105287
(43) Veröffentlichungstag der Anmeldung: 07.08.2002
(73) Patentinhaber: Fujitsu Siemens Computers GmbH, 80807 München (DE)
(72) Erfinder: Knoop, Franz-Josef, 33142 Büren-Steinhausen (DE); Schmidt, Heinrich, 33129 Delbrück (DE)
(74) Vertreter: Epping - Hermann - Fischer

(56) Entgegenhaltungen:
- WO-A-97/40652
- FR-A- 2 495 705
- US-A- 5 940 274
- US-A- 6 036 290

## Beschreibung

Die Erfindung betrifft ein Serverrack mit vier Racksäulen, einem Kopf- und einem Fußteil, wobei die vier Racksäulen untereinander identisch und das Kopf- und Fußteil ebenfalls untereinander identisch ausgebildet sind.

Ein derartiger Stand der Technik ist aus den Druckschriften DE 298 14 721 U1 und US 6,036,290 bekannt.

Die Druckschrift DE 198 11 714 A1 zeigt Steckansätze in den vier Eckbereichen des Bodenteiles angeordnet, über die vertikale Rahmenprofile gesteckt werden können. Die vertikalen Rahmenprofile sind als Vierkanthohlprofile ausgebildet, deren Innenquerschnitt in etwa dem Außenquerschnitt der Steckansätze entspricht.

Druckschrift DE 94 21 484 U1 zeigt rechtwinklig abgebogene Flansche, die zur Aufnahme von aufrecht stehenden Hohlprofilstäben dienen.

Serverracks müssen kostengünstig herstellbar sein. Um das gleiche Rack für verschiedene Größen zu verwenden, ist es günstig, dies modular aufzubauen und zueinander beziehungsweise aufeinander stapeln zu können.

Der Erfindung liegt daher die Aufgabe zugrunde, das gattungsgemäße Serverrack weiterzubilden, sodass es nicht nur kostengünstig herstellbar ist, sondern auch Vorkehrungen für die Stapelbarkeit aufweist.

Diese Aufgabe wird dadurch gelöst, dass in das Kopfbeziehungsweise Fußteil von außen in Richtung einer jeweiligen Racksäule ein Knotenstück eingesetzt ist und das Knotenstück ein Boden-/Deckenstück und zumindest zwei davon rechwinklig abgebogenen Flansche aufweist, wobei das Knotenstück mittels Durchstecken der Flansche durch entsprechende Schlitze im Kopf- beziehungsweise Fußteil zur Verbindung des Kopfbeziehungsweise Fußteils mit der jeweiligen Racksäule dient, und das Boden-/Deckenstück des Knotenstücks eine Bohrung aufweist.

Durch diese Merkmale wird eine weitere Kosteneinsparung erzielt, da Standardteile verwendet werden können, die verschraubt oder vernietet werden können. Ebenso wird erreicht, daß die Serverracks mit einem Kugelfuß versehen werden können und sich die Kugelfüße automatisch in den Bohrungen zentrieren. Damit wird die, für hochpreisige Geräte wie für Serverracks wichtige, fluchtende Ausrichtung sichergestellt. Durch Vernieten mit der Racksäule wird automatisch das Kopf- beziehungsweise Fußteil über das Knotenstück an der Racksäule festgelegt.

Die Flansche sind bevorzugt t-förmig aus breiten Bereichen und sich daran anschließenden schmalen Bereichen gebildet, wobei die schmalen Bereiche durch die entsprechenden Schlitze im Kopf- beziehungsweise Fußteil gesteckt sind und sich die breiten Bereiche an dem Kopf- beziehungsweise Fußteil abstützen. Über das Durchstecken der schmäleren Bereiche der t-förmigen Flansche durch die Schlitze im Kopfbeziehungsweise Fußteil und dem anschließenden Vernieten der schmalen Bereiche der Flansche mit den Racksäulen wird erreicht, dass über die breiten Bereiche der t-förmigen Flansche das Kopf- beziehungsweise Fußteil gegen die Racksäule gepresst wird.

Vorteilhaft ist das Serverrack zur Stapelbarkeit am jeweiligen Bodenstück über die Bohrung mit einem Kugelfuß verbunden, welcher mit der Bohrung im jeweiligen Deckenstück des darunter liegenden Serverracks derart zusammenwirkt, dass das darauf liegende Serverrack in seiner Lage ausgerichtet beziehungsweise zentriert ist. Somit können die Serverracks ohne weiteres aufeinander gestapelt werden. Die Kugelfüße im oberen Serverrack werden dabei exakt in den Bohrungen des Deckenstücks im Knotenteil des unteren Serverracks aufgenommen.

Die Kugelfüße sind günstiger Weise in einem Stapelrahmen integriert, welcher einfach in die Unterseite des Serverracks über die Bohrungen im Bodenteil angesteckt beziehungsweise angeschraubt wird.

Die aufeinander gestapelten Serverracks sind vorzugsweise über einen Blendenrahmen, der gleichzeitig auch die Verkleidung darstellt, miteinander verbunden.

Nachfolgend wird die Erfindung anhand eines in den Zeichnungen dargestellten Ausführungsbeispieles näher erläutert.

In den Zeichnungen zeigen
Figur 1 in Schrägansicht die obere Ecke beziehungsweise die untere Ecke von zwei aufeinandergestapelten Serverracks,
Figur 2 die Ansicht gemäß Figur 1 in Schnittdarstellung,
Figur 3 eine Schrägansicht eines Serverracks,
Figur 4 zwei aufeinandergestapelte Serverracks und
Figur 5 drei aufeinandergestapelte Serverracks

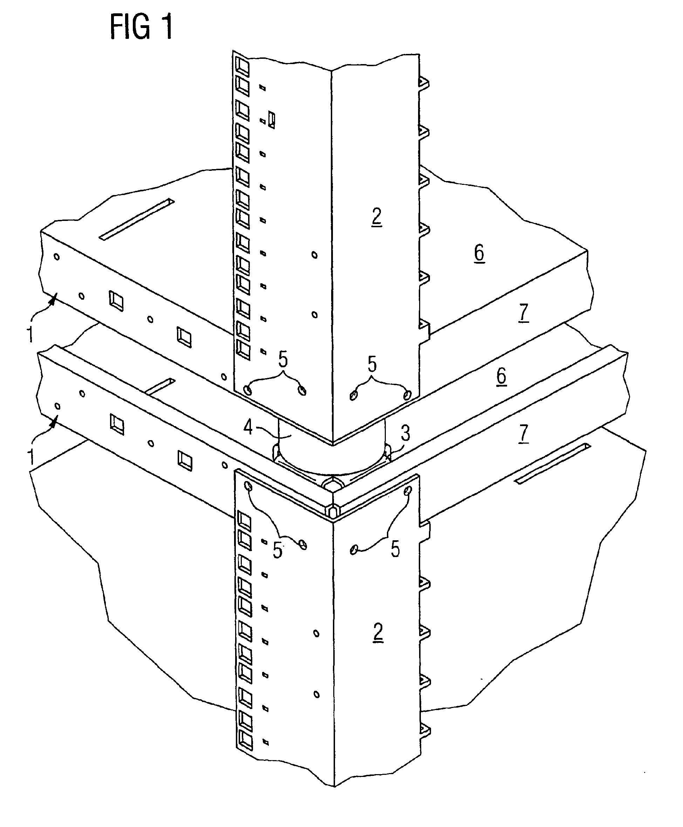

Figur 1 zeigt in Schrägansicht die obere Ecke eines unteren Serverracks und die untere Ecke eines oberen Serverracks im aufeinandergestapelten Zustand.

Die Serverracks bestehen jeweils aus einem Kopfbeziehungsweise Fußteil 1, vier jeweils an den Ecken angeordneten Racksäulen 2, und einem Knotenstück 3, welches zum einem zur Verbindung des Kopf- beziehungsweise Fußteiles 1 und der Racksäulen 2 dient und zum anderen die Stapelbarkeit der Serverracks gewährleistet. Zum Stapeln der Serverracks sind zwischen den Knotenstücken 3 jeweils sogenannte Kugelfüße 4 angeordnet.

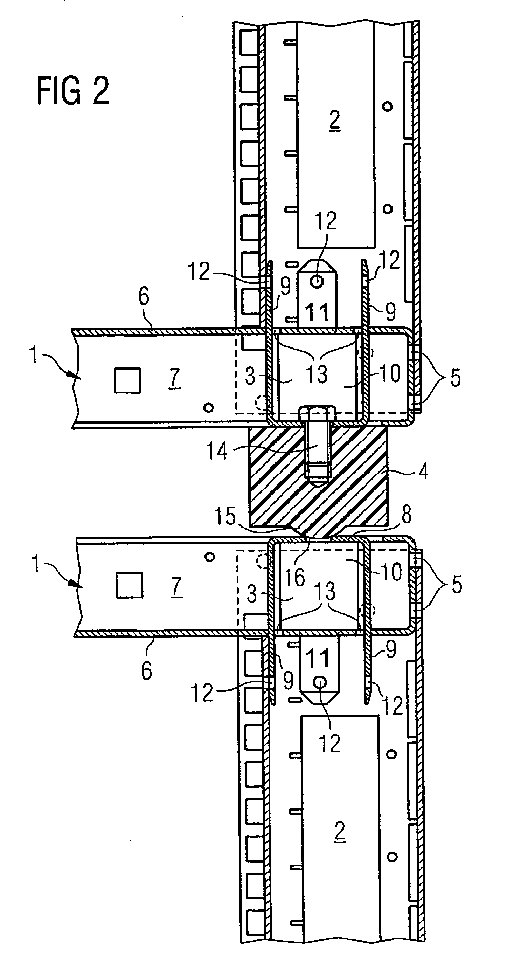

Das Boden- beziehungsweise Kopfteil 1 wird mit den Racksäulen 2 an den äußeren Längsseiten über die Bohrungen 5 vernietet. Die inneren Seiten der Racksäulen werden mit dem Knotenstück 3, wie in Figur 2 näher erläutert wird, vernietet.

Das Kopfteil beziehungsweise Bodenteil 1 besteht aus einer Platte 6 und davon senkrecht abgewinkelten Seitenwänden 7, sodass insgesamt mehr oder weniger eine Wanne gebildet ist.

Figur 2 zeigt die Ansicht gemäß Figur 1 in Schnittdarstellung mit Schnitt durch das Zentrum des Kugelfußes 4.

Die verdeckt dargestellten Elemente sind gestrichelt eingezeichnet.

Das Knotenstück 3 besteht jeweils aus einem Bodenbeziehungsweise Deckenstück 8 und vier davon rechtwinklig abgebogenen Flanschen 9, welche jeweils t-förmig ausgebildet sind und einen breiten Bereich 10 sowie einen schmalen Bereich 11 aufweisen. Im schmalen Bereich 11 ist an der Spitze jeweils eine Bohrung 12 vorgesehen, über welche jeweils eine Vernietung mit der Innenseite der Racksäule 2 erfolgt.

In der Bodenplatte 6 sind Schlitze 13 ausgebildet, durch die jeweils die schmalen Bereiche 11 der Flansche 9 gesteckt werden und welche in ihrer Größe so dimensioniert sind, dass sich die breiten Bereiche 10 der Flansche 9 an der Bodenplatte 6 abstützen.

Durch diese Konstruktion ist gewährleistet, dass durch das Vernieten über die Bohrungen 12 mit den Innenseiten der Racksäulen 2 das Kopf- beziehungsweise Fußteil 1 schon an den Racksäulen 2 fixiert ist.

Zum anderen wird erreicht, dass beim Stapeln der Serverracks die Kraft direkt über das Knotenstück 3 in das Kopfbeziehungsweise Fußteil 1 über die breiten Bereiche 10 der Flansche 9 und zum anderen gleichzeitig in die Innenseiten der Racksäulen 2 über in den Bohrungen 12 vorgesehene Nietverbindungen eingeleitet wird.

Zur Stapelbarkeit der Serverracks ist zwischen den Knotenstücken 3 der Serverracks jeweils ein Kugelfuß 4 vorgesehen, welcher am oberen Knotenstück 3 über eine Schraube 14 fixiert ist. An der unteren Seite weist der Kugelfuß 4 eine kugelsegmentartige Auswölbung 15 auf, welche in eine entsprechende Bohrung 16 im Knotenstück 3 beim Stapeln der Serverracks aufgenommen wird und somit die Serverracks beim Aufeinanderstapeln zentriert.

Über die Bohrung 16 erfolgt auch im oberen Knotenstück 3 die Verschraubung mit dem Kugelfuß 4.

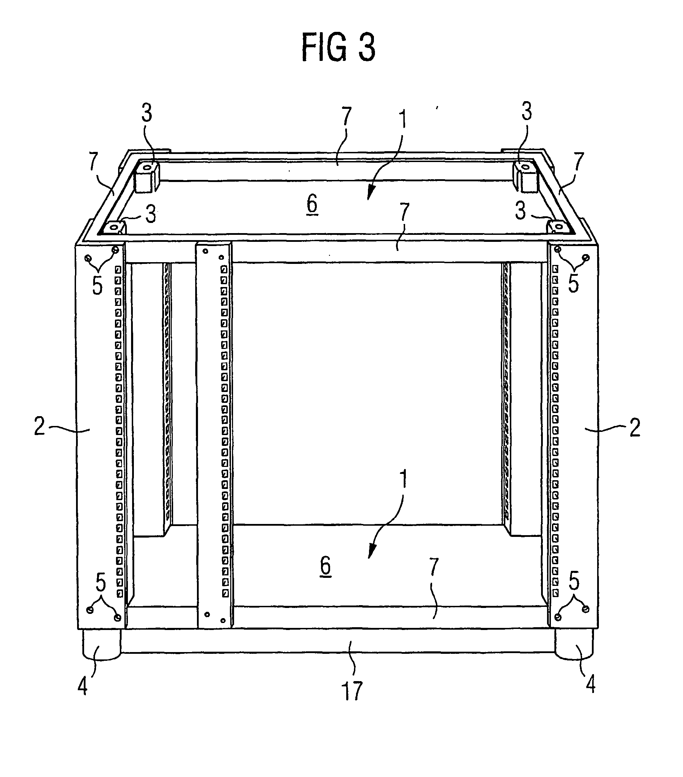

In Figur 3 ist ein komplettes Serverrack in Schrägansicht dargestellt.

Die Kugelfüße 4 sind über einen Stapelrahmen 17 verbunden, der beim Aufeinanderstapeln der Serverracks jeweils dazwischen angeordnet ist.

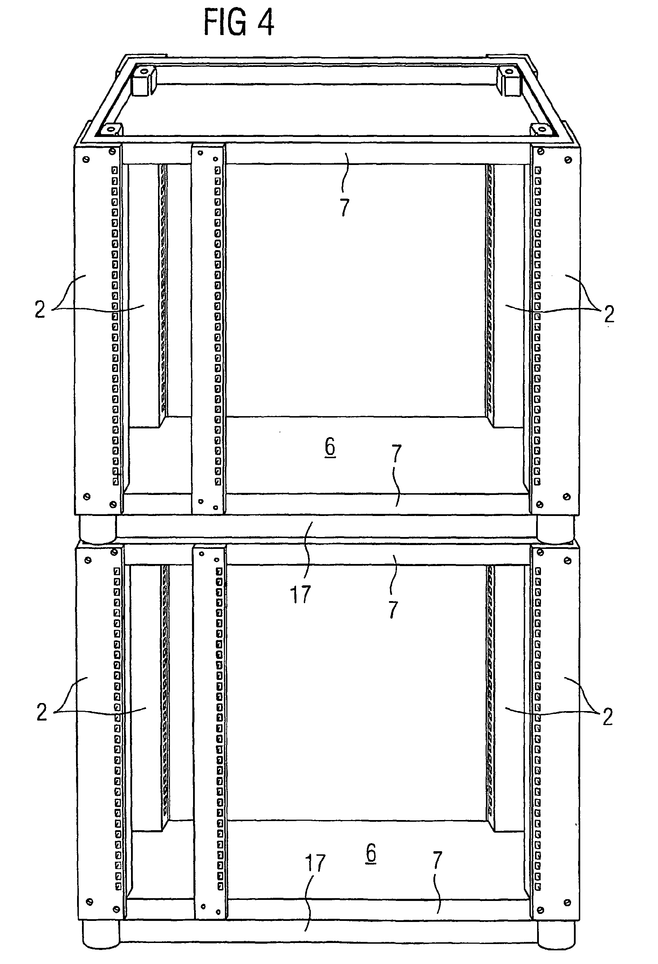

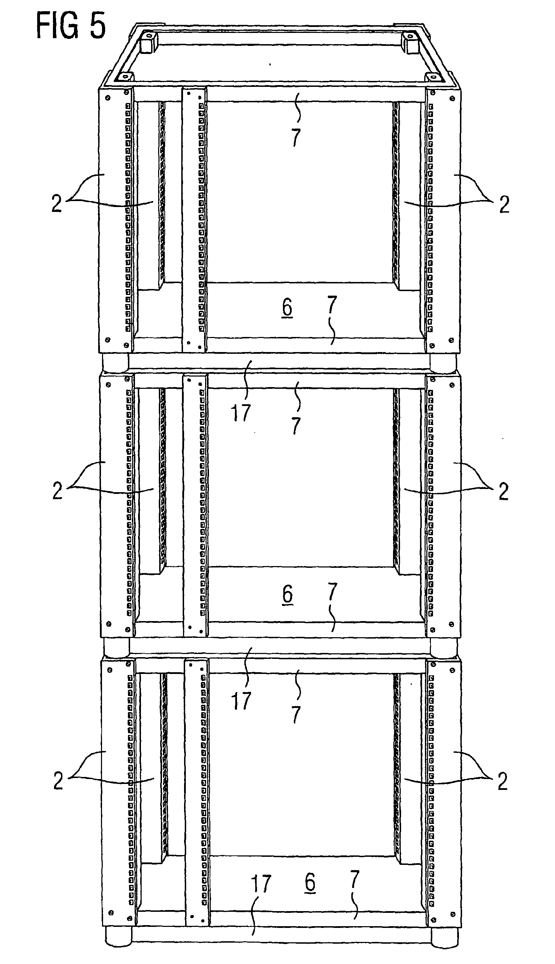

Figur 4 zeigt zwei aufeinandergestapelte Serverracks und Figur 5 drei aufeinandergestapelte Serverracks mit jeweils dazwischenliegenden Stapelrahmen 17 in Seitenansicht.

Das in den Figuren dargestellte Serverrack ist jeweils für 12 Höheneinheiten ausgelegt.

Ebenso gibt es gleichartig aufgebaute Serverracks mit 38 Höheneinheiten.

Ausgehend von einer Raumhöhe von 2,50 m können somit entweder vier Serverracks mit je 12 Höheneinheiten beziehungsweise ein Serverrack mit 38 Höheneinheiten und eines mit 12 Höheneinheiten aufeinandergestapelt werden.

Im aufeinandergestapelten Zustand werden die Serverracks lediglich an der Außenseite mit einem Blendenrahmen versehen, welcher zum einen eine Verkleidung darstellt und zum anderen ein Verrutschen der Serverracks trotz der Verrastung der Kugelfüße 4 in den Bohrung 16 der Knotenstücke 3 ausschließt.

## Patentansprüche

1. Serverrack mit vier Racksäulen (2), einem Kopf- und einem Fußteil (1), wobei die vier Racksäulen (2) untereinander identisch und das Kopf- und Fußteil (1) ebenfalls untereinander identisch ausgebildet sind,
**dadurch gekennzeichnet, dass**
a) in das Kopf- beziehungsweise Fußteil (1) von außen in Richtung einer jeweiligen Racksäule (2) ein Knotenstück (3) eingesteckt ist,
b) das Knotenstück (3) ein Boden-/Deckenstück (8) und zumindest zwei davon rechtwinklig abgebogene Flansche (9) aufweist, wobei das Knotenstück (3) mittels Durchstecken der Flansche (9) durch entsprechende Schlitze (13) im Kopfbeziehungsweise Fußteil (1) zur Verbindung des Kopfbeziehungsweise Fußteils (1) mit der jeweiligen Racksäule (2) dient,
c) das Boden-/Deckenstück (8) des Knotenstücks (3) eine Bohrung (16) aufweist die zur Stapelbarkeit des Serverracks dient.

2. Serverrack nach Anspruch 1,
**dadurch gekennzeichnet, dass**
die Racksäulen (2) mit dem Kopf- beziehungweise Fußteil (1) zu vernieten sind.

3. Serverrack nach Anspruch 1 oder 2,
**dadurch gekennzeichnet, dass**
die Flansche (9) t-förmig aus breiten Bereichen (10) und sich daran anschließenden schmalen Bereichen (11) gebildet sind, wobei die schmalen Bereiche (11) durch die entsprechenden Schlitze (13) im Kopf- beziehungsweise Fußteil (1) gesteckt sind und sich die breiten Bereiche (10) an dem Kopfbeziehungsweise Fußteil (1) abstützen.

4. Serverrack nach Anspruch 3,
**dadurch gekennzeichnet, dass**
eine Vernietung zwischen den schmalen Bereichen (11) der t-förmigen Flansche (9) des Knotenstücks (3) und der Racksäule (2) erfolgt.

5. Serverrack nach einem der Ansprüche 1 bis 4,
**dadurch gekennzeichnet, dass**
das Serverrack zur Stapelbarkeit am jeweiligen Bodenstück (8) über die Bohrung (16) mit einem Kugelfuß (4) verbunden ist, welcher mit der Bohrung (16) im jeweiligen Deckenstück (8) des darunter liegenden Serverracks derart zusammenwirkt, dass das darauf liegende Serverrack in seiner Lage ausgerichtet beziehungsweise zentriert ist.

6. Serverrack nach Anspruch 5,
**dadurch gekennzeichnet, dass**
die Kugelfüße (4) in einem Stapelrahmen (17) integriert sind.

7. Stapel bestehend aus Serverracks nach einem der Ansprüche 1 bis 6, wobei die Serverracks über einen Blendenrahmen verbunden sind.

## Claims

1. Rack for server having four rack pillars (2), a head and a foot part (1), with the four rack pillars (2) being identical to one another and the head and foot part (1) likewise being identical to one another,
**characterized in that**
a) a junction piece (3) is inserted into the head or foot part (1) from outside in the direction of a respective rack pillar (2),
b) the junction piece (3) has a base/top piece (8) and at least two flanges (9) which are bent away from the said base/top piece at a right angle, with the junction piece (3) serving to connect the head or foot part (1) to the respective rack pillar (2) by means of pushing the flanges (9) through corresponding slots (13) in the head or foot part (1), and
c) the base/top piece (8) of the junction piece (3) has a hole (16) which facilitates stacking of the rack for server.

2. Rack for server according to Claim 1,
**characterized in that** the rack pillars (2) are to be riveted to the head or foot part (1).

3. Rack for server according to Claim 1 or 2,
**characterized in that** the flanges (9) are in a t-shape comprising broad regions (10) and narrow regions (11) which adjoin the said broad regions (10), with the narrow regions (11) being pushed through the corresponding slots (13) in the head or foot part (1), and the broad regions (10) being supported on the head or foot part (1).

4. Rack for server according to Claim 3,
**characterized in that** riveting is performed between the narrow regions (11) of the t-shaped flanges (9) of the junction piece (3) and the rack pillar (2).

5. Rack for server according to one of Claims 1 to 4, **characterized in that** the rack for server is connected, by means of the hole (16), to a spherical foot (4) in order to be able to be stacked on the respective base piece (8), the said spherical foot interacting with the hole (16) in the respective top piece (8) of the rack for server beneath it in such a way that the position of the rack for server situated on top of the said spherical foot is aligned or centred.

6. Rack for server according to Claim 5,
**characterized in that** the spherical feet (4) are integrated in a stack frame (17).

7. Stack comprising rack for server according to one of Claims 1 to 6, with the rack for server being connected by means of a panel frame.

## Revendications

1. Rack pour serveur comprenant quatre montants de rack (2), une partie de tête et une partie de base (1), les quatre montants de rack (2) étant réalisés de manière identique les uns aux autres et la partie de tête et la partie de base (1) étant également réalisées de manière identique l'une à l'autre,
**caractérisé en ce que**
a) une pièce de liaison (3) est insérée dans la partie de tête ou dans la partie de base (1) depuis l'extérieur dans la direction d'un montant de rack respectif (2),
b) la pièce de liaison (3) présente une pièce de fond/dessus (8) et au moins deux brides (9) recourbées à angle droit par rapport à celle-ci, la pièce de liaison (3), au moyen d'un perçage des brides (9) par des fentes correspondantes (13) dans la partie de tête, respectivement de base (1), sert à la connexion de la partie de tête, respectivement de base (1) au montant de rack respectif (2),
c) la pièce de fond/dessus (8) de la pièce de liaison (3) présente un alésage (16) qui sert à empiler le rack pour serveur.

2. Rack pour serveur selon la revendication 1,
**caractérisé en ce que**
les montants de rack (2) peuvent être rivetés à la partie de tête, respectivement de base (1).

3. Rack pour serveur selon la revendication 1 ou 2,
**caractérisé en ce que**
les brides (9) sont formées en forme de t à partir de régions larges (10) et de régions étroites (11) raccordées à celles-ci, les régions étroites (11) étant enfichées à travers les fentes correspondantes (13) dans la partie de tête, respectivement de base (1) et les régions larges (10) s'appuyant sur la partie de tête, respectivement de base (1).

4. Rack pour serveur selon la revendication 3,
**caractérisé en ce**
**qu'**on effectue un rivetage entre les régions étroites (11) des brides en forme de t (9) de la pièce de liaison (3) et du montant de rack (2).

5. Rack pour serveur selon l'une quelconque des revendications 1 à 4,
**caractérisé en ce que**
le rack pour serveur, pour permettre de l'empiler, est connecté au niveau de la pièce de fond (8) respective par le biais de l'alésage (16) à un pied sphérique (4), qui coopère avec l'alésage (16) dans la pièce de dessus respective (8) du rack pour serveur sous-jacent, de telle sorte que le rack pour serveur situé par-dessus soit centré respectivement orienté dans sa position.

6. Rack pour serveur selon la revendication 5,
**caractérisé en ce que**
les pieds sphériques (4) sont intégrés dans un cadre d'empilage (17).

7. Pile constituée de racks pour serveur selon l'une quelconque des revendications 1 à 6, dans laquelle les racks pour serveur sont connectés par le biais d'un châssis dormant.
